# EUROPÄISCHE PATENTSCHRIFT

(11) **EP 2 281 310 B1**
(45) Veröffentlichungstag und Bekanntmachung des Hinweises auf die Patenterteilung: **25.09.2019**
(21) Anmeldenummer: 09749622.8
(22) Anmeldetag: 19.05.2009
(51) Int. Cl.: H01L 31/0749, H01L 31/032

(54) **SCHICHTSYSTEM FÜR SOLARZELLEN**
LAYER SYSTEM FOR SOLAR CELLS
SYSTÈME MULTICOUCHE POUR CELLULES SOLAIRES

(30) Priorität: 19.05.2008 DE 102008024230
(43) Veröffentlichungstag der Anmeldung: 09.02.2011
(73) Patentinhaber: (CNBM) Bengbu Design & Research Institute for Glass Industry Co., Ltd., Bengbu (CN)
(72) Erfinder: Palm, Jörg, 80797 München (DE)
(74) Vertreter: Gebauer, Dieter Edmund
(86) Internationale Anmeldenummer: PCT/EP2009/003587
(87) Internationale Veröffentlichungsnummer: WO 2009/141132

(56) Entgegenhaltungen:
- DE-A1-102006 039 331
- JP-A- 11 026 790
- LOKHANDE C D ET AL: "Chemical bath deposition of indium sulphide thin films: preparation and characterization" THIN SOLID FILMS, ELSEVIER-SEQUOIA S.A. LAUSANNE, CH LNKD- DOI:10.1016/S0040-6090(98)00980-8, Bd. 340, Nr. 1-2, 26. Februar 1999 (1999-02-26), Seiten 18-23, XP004164221 ISSN: 0040-6090
- QASRAWI ET AL: "Temperature dependence of the band gap, refractive index and single-oscillator parameters of amorphous indium selenide thin films" OPTICAL MATERIALS, ELSEVIER SCIENCE PUBLISHERS B.V. AMSTERDAM, NL, Bd. 29, Nr. 12, 23. Juni 2007 (2007-06-23) , Seiten 1751-1755, XP022126850 ISSN: 0925-3467
- E. RUDIGIER, J. PALM, R. SCHEER: "Towards a fast process control for Cu(In,Ga)(Se,S)2 absorbers. The surface chalcogen ratio assesed by Raman spectroscopy" PROCEEDINGS OF THE 19TH EUROPEAN PHOTOVOLTAIC SOLAR ENERGY CONFERENCE, 7. Juni 2004 (2004-06-07), - 11. Juni 2004 (2004-06-11) Seiten 1913-1916, XP002585523
- YOUSFI E B ET AL: "Atomic layer deposition of zinc oxide and indium sulfide layers for Cu(In,Ga)Se"2 thin-film solar cells", THIN SOLID F, ELSEVIER, AMSTERDAM, NL, vol. 387, no. 1-2, 29 May 2001 (2001-05-29), pages 29-32, XP004232903, ISSN: 0040-6090, DOI: 10.1016/S0040-6090(00)01838-1

## Beschreibung

Die vorliegende Erfindung betrifft ein Schichtsystem für DünnschichtSolarzellen gemäß dem Oberbegriff des Anspruchs 1 und Solarzellen oder Solarzellenmodule mit diesem Schichtsystem.

Dünnschichtsysteme für Solarzellen und Solarmodule sind hinreichend bekannt und in verschiedenen Ausführungen, je nach Substrat und aufgebrachten Materialien, auf dem Markt vorhanden. Die Materialien werden so gewählt, dass das einfallende Sonnenspektrum maximal ausgenutzt wird. Derzeitig sind Dünnschichtzellen aus Halbleitermaterialien kommerziell erhältlich, beispielsweise aus Cadium-Tellurid (CdTe), oder Kupfer-Indium(Gallium)-Schwefel-Selen-Verbindungen (Cu(In/Ga)(Se/S)), bekannt als CIS- bzw. CIGS-Zellen, wobei hier je nach Zelltyp S für Schwefel und/oder für Selen stehen kann. Am häufigsten wird amorphes Silizium (a:Si:H) für Dünnschichtzellen verwendet. Inzwischen erreichen CIS-Dünnschichtzellen die annähernd die gleichen Wirkungsgrade wie Module aus multikristallinem Silizium.

Aktuelle Dünnschichtsolarzellen und Solarmodule auf Basis von Cu(In,Ga)(S,Se)₂ benötigen eine Pufferschicht zwischen p-leitendem Cu(In,Ga)(S,Se)₂-Absorber und n-leitender Frontelektrode, die üblicherweise Zinkoxid (ZnO) umfasst. Nach derzeitiger Erkenntnis ermöglicht diese Pufferschicht eine elektronische Anpassung zwischen Absorbermaterial und Frontelektrode. Sie bietet außerdem einen Schutz vor Sputterschäden im nachfolgenden Prozessschritt der Abscheidung der Frontelektrode durch DC-MagnetronSputtern. Zusätzlich verhindert sie durch Aufbau einer hochohmigen Zwischenschicht zwischen p- und n-Halbleiter den Stromabfluss von elektronisch guten in schlechte Bereiche.

Bisher wurde am häufigsten Kadmiumsulfid (CdS) als Pufferschicht verwendet. Um gute Wirkungsgrade der Zelle erzeugen zu können, wurde CdS bisher in einem CBD-Prozess (chemischer Badprozess) nasschemisch abgeschieden. Damit ist allerdings der Nachteil verbunden, dass der nasschemische Prozess nicht gut in den Prozessablauf der gegenwärtigen Produktion von Cu(In,Ga)(S,Se)₂-Dünnschichtsolarzellen passt.

Ein weiterer Nachteil der CdS-Pufferschicht besteht darin, dass sie das toxische Schwermetall Kadmium enthält. Dadurch entstehen höhere Produktionskosten, da erhöhte Sicherheitsvorkehrungen im Produktionsprozess, z.B. bei der Entsorgung des Abwassers, getroffen werden müssen. Die Entsorgung des Produktes kann auch unter Umständen für den Kunden höhere Kosten verursachen, da der Hersteller je nach örtlicher Gesetzgebung zur Rücknahme, zur Entsorgung oder zum Recycling des Produktes gezwungen werden könnte und die dadurch entstehenden Kosten an die Kunden weitergeben würde.

Es wurden daher verschiedene Alternativen zum Puffer aus CdS für unterschiedliche Absorber aus der Familie der Cu(In,Ga)(S,Se)₂-Halbleiter getestet; beispielsweise gesputtertes ZnMgO, durch CBD abgeschiedenes Zn(S,OH), durch CBD abgeschiedenes In(O,OH) und Indiumsulfid, abgeschieden durch ALD (A-tomicLayer Deposition), ILGAR (Ion Layer Gas Deposition), Spray Pyrolose oder PVD (Physical Vapor Deposition)-Verfahren, wie z.B. thermisches Verdampfen oder Sputtern.

Allerdings eignen sich diese Materialien noch nicht als Puffer für die Solarzellen auf Basis von Cu(In,Ga)(S,Se)₂ für eine kommerzielle Nutzung, da sie nicht die gleichen Wirkungsgrade (Verhältnis von eingestrahlter Leistung zur erzeugten elektrischen Leistung einer Solarzelle) erreichen, wie solche mit einer CdS-Pufferschicht, die etwa bis nahezu 20 % für Laborzellen auf kleinen Flächen sowie zwischen 10% und 12% für großflächige Module liegen. Weiterhin zeigen sie zu große Instabilitäten, Hystereseeffekte oder Degradationen im Wirkungsgrad, wenn sie Licht, Wärme und/oder Feuchte ausgesetzt sind.

Ein weiterer Nachteil von CdS liegt darin begründet, dass CdS ein direkter Halbleiter mit einer direkten elektronischen Bandlücke von etwa 2.4 eV ist und daher in einer Cu(In,Ga)(S,Se)₂/CdS/ZnO-Solarzelle schon bei CdS-Schichtdicken von einigen 10 nm das einfallende Licht absorbiert wird. Da es in diesem Bereich des Heteroübergangs und im Puffermaterial viele Kristalldefekte, d.h. Rekombinationszentren gibt, rekombinieren die erzeugten Ladungsträger in dieser Schicht gleich wieder. Damit geht das in der Pufferschicht absorbierte Licht für die elektrische Ausbeute verloren, d.h. der Wirkungsgrad der Solarzelle wird kleiner, was für eine Dünnschichtzelle nachteilig ist.

LOKHANDE CD ET AL: "Chemical bath deposition of indium sulphide thin films: preparation and characterization"THIN SOLID FILMS, ELSEVIER-SEQUOIA S.A. LAUSAN-NE, CH LNKD- DOI: 10.1016/S0040-6090(98)00980-8, Bd. 340, Nr. 1-2, 26. Februar 1999 (1999-02-26), Seiten 18-23, und QASRAWI ET AL: "Temperature dependence of the band gap, refractive index and single-oscillator parameters of amorphous indium selenide thin films"OPTICAL MATERIALS, ELSEVIER SCIENCE PUBLISHERS B.V. AMS-TERDAM, NL, Bd. 29, Nr. 12, 23. Juni 2007 (2007-06-23), Seiten 1751-1755 zeigen jeweils ein Schichtsystem gemäß dem Oberbegriff von Patentanspruch 1.

Aufgabe der vorliegenden Erfindung ist es daher, ein Schichtsystem auf Basis von Cu(In,Ga)(S,Se)₂ für Solarzellen oder Solarmodule mit einer Pufferschicht bereitzustellen, das einen hohen Wirkungsgrad und hohe Stabilität aufweist, wobei die Herstellung kostengünstig und umweltverträglich sein soll. Diese Aufgabe wird erfindungsgemäß durch ein Schichtsystem gemäß Anspruch 1 und eine Solarzelle oder ein Solarzellenmodul nach Anspruch 9 gelöst. Vorteilhafte Weiterbildungen der Erfindung ergeben sich aus den Unteransprüchen.

Das Schichtsystem umfasst eine Absorberschicht aus einem Verbindungshalbleitermaterial mit Chalkopyritstruktur (Cu(In,Ga)(S_{1-y},Se_{y})₂, wobei 0 ≤ y ≤ 1 gilt) und eine erste Pufferschicht, wobei die erste Pufferschicht In₂(S₁₋ₓ,Seₓ)_{3+δ} (Indiumsulfidselenid) umfasst und 0 ≤ x ≤ 1 gilt. Die In₂(S₁₋ₓ, Seₓ)_{3+δ}-Pufferschicht ist weiterhin amorph ausgebildet.

Die mit diesem Schichtsystem hergestellten Solarzellen zeigen hohe Wirkungsgrade bei gleichzeitig hoher Langzeitstabilität. Da nunmehr keine toxischen Substanzen mehr zum Einsatz kommen, ist das Herstellungsverfahren umweltschonender und billiger und es entstehen auch keine Nachfolgekosten, wie bei CdS-Pufferschichten.

Im Einzelnen hat sich überraschend gezeigt, dass mit dem erfindungsgemäßen Schichtsystem vergleichbar gute Solarzellencharakteristika erreicht werden können, wie sie bei herkömmlichen CdS-Pufferschichten vorliegen. Mit dem erfindungsgemäßen Aufbau können nämlich hohe Wirkungsgrade von 12,2% bis 14,3% erreicht werden.

Amorph im Kontext der vorliegenden Erfindung heißt, dass bei Röntgenstrukturuntersuchungen die Signale, die eine kristalline Struktur widerspiegeln, unter der Nachweisgrenze liegen. Außerdem zeigt das Raman Spektrum (bei 488nm Anregungswellenlänge) der Schichten im Bereich von 220cm⁻¹ und 380cm⁻¹ Wellenzahlen eine breite Bande mit Maximum bei 290cm⁻¹, in der keine Einzellinien mehr auflösbar sind. Bei den dieser Erfindung zu Grunde liegenden Untersuchungen hatte sich gezeigt, dass die Indiumsulfid-Schichten auf den Glassubstraten in der Regel amorph aufgewachsen waren. Auf den Absorberschichten waren sie je nach Prozessbedingungen entweder amorph oder kristallin. Überraschenderweise ergaben nur die Schichtsysteme besonders gute Wirkungsgrade größer als 12% bei denen die Indiumsulfid-Schicht auf dem Absorber amorph aufgewachsen war. Schichten mit kristallinem Indiumsulfid ergaben Wirkungsgrade zwischen 6 und 12%.

Bevorzugt enthält die erste Pufferschicht keine Verunreinigungen, d.h. sie ist nicht absichtlich mit weiteren Elementen, wie Sauerstoff, Kohlenstoff oder Chlor versehen und enthält diese höchstens im Rahmen fertigungstechnisch nicht vermeidbarer Konzentrationen von kleiner gleich 1 Mol %. Dadurch lässt sich ein hoher Wirkungsgrad sicherstellen.

Erfindungsgemäß liegt die als "δ" bezeichnete Abweichung von der Stöchiometrie zwischen -0,2 und 0. Es wird dabei ein Wert bevorzugt, der etwa bei δ=-0,1 liegt, da mit dieser leicht indiumreichen Zusammensetzung die besten Zellen erreicht werden konnten.

Durch die amorphe Ausbildung der ersten Pufferschicht wird der hohe Wirkungsgrad weitgehend bestimmt. Untersuchungen zeigen nämlich einen reziproken Zusammenhang zwischen Wirkungsgrad und Kristallinität für die hier verwendeten Schichten und Abscheideverfahren. Je weniger kristallin, d.h. je amorpher die Struktur ist, desto vorteilhafter ist dies für den Wirkungsgrad. Außerdem können amorphe Schichten bei geringeren Temperaturen hergestellt werden, wodurch eine massive Interdiffusion der Elemente zwischen Puffer und Absorber vermieden werden und die Herstellung allgemein erleichtert wird. Amorphe Halbleiterschichten werden in Solarzellen bisher nur bei amorphen Silizium-Germanium Schichtsystemen sowie bei Heteroübergängen aus kristallinen und amorphen Silizium verwendet. Für Chalkopyrithalbleiter sind Kombinationen mit amorphen Puffer oder amorphen Frontelektroden bisher nicht bekannt.

Ein weiterer Vorteil des erfindungsgemäßen Schichtsystems besteht darin, dass die Zellen eine höhere Stabilität gegen Temperatur, Licht, Feuchtigkeit, sowie mechanische und elektrische Spannung aufweisen. Bei den bisherigen Solarzellen auf Chalkopyritbasis werden nämlich oft Hystereseffekte beobachtet: der Wirkungsgrad kann durch Einwirkung von Wärme und/oder Feuchtigkeit degradiert werden. Durch Beleuchtung kann zwar der Wirkungsgrad teilweise wieder hergestellt werden. Im ungünstigen Fall bleiben jedoch irreversible Verluste. In manchen Fällen stellt sich der Wirkungsgrad nach Herstellung der Zellen erst durch lange Beleuchtung (Light Soaking) ein. Bei den mit dem erfindungsgemäßen Schichtsystem hergestellten Solarzellen zeigen die Messungen des Alterungseffekts unter feuchter Hitze (85% relative Feuchtigkeit, 85 °C Temperatur) dagegen, dass sich die unverkapselten oder verkapselten Zellen gleich oder besser als solche mit CdS-Pufferschicht und ZnO-Frontelektrode verhalten. Die Lichtexposition von erfindungsgemäßen Zellen verursacht auch wenig Änderung des Wirkungsgrades, nämlich weniger als 5%, was eine merkliche Verbesserung der Stabilität des Schichtsystems ist.

Aus Messungen der optischen Transmission als Funktion der Wellenlänge von In₂(S₁₋ₓ,Seₓ)_{3+δ}-Schichten auf Glas wurde mit Hilfe von Tauc Plots festgestellt, dass die Bandlücke E_{G} der ersten Pufferschicht zwischen 2,0 und 2,2 eV liegt. Diese Bandlücke ist zwar kleiner als die von CdS, jedoch ist CdS ein direkter Halbleiter, während die Auswertung der Tauc Plots zeigten, das die verwendeten In₂(S₁₋ₓ,Seₓ)_{3+δ}-Schichten eine direkt und verbotene oder indirekte Natur der Bandlücke aufweisen, wodurch eine geringere Absorption des Lichtes in der Pufferschicht bei vergleichbaren Schichtdicken möglich ist. Eine geringere optische Absorption führt jedoch höheren Wirkungsgrad für die Umwandlung von Licht in elektrische Leistung.

Bevorzugt liegt der Selengehalt x zwischen 0 und 0,5, bevorzugt zwischen 0 und 0,1. Minimale Selengehalte x können zweckmäßig sein, z. B. mit x = 0,08, x = 0,05, x = 0,03, x = 0,01 oder x = 0,001. Der Selengehalt kann tatsächlich auch x = 0 sein. Durch die Variation des Selengehalts kann die Bandlücke der ersten Pufferschicht und deren Bandanpassung zur Absorberschicht aus Cu(In,Ga)(S,Se)₂ erfolgen, wobei bei diesen Selengehalten der Wirkungsgrad am höchsten ist. Durch die Einstellung des Selengehalts ist also eine Feinabstimmungen der Bandlücke und der Bandanpassung gegenüber In₂(S₁₋ₓ,Seₓ)_{3+δ} möglich, wodurch der Wirkungsgrad zusätzlich erhöht werden kann.

Erfindungsgemäß umfasst die Absorberschicht Cu(In,Ga)(S,Se)₂ mit einem Verhältnis der molaren Konzentrationen [S]/([Se]+[S]) an der Oberfläche der Absorberschicht zwischen 20% bis 60%, und bevorzugt 35%, wodurch der Schwefel in das Anionengitter der Chaclopyritstruktur eingebaut wird. Auch hierdurch lässt sich eine Feinabstimmung der Bandlücke und der Bandanpassung gegenüber In₂(S₁₋ₓ,Seₓ)_{3+δ} erzielen.

Es lässt sich feststellen, dass die Kombination der Pufferschicht mit der Absorberschicht von der richtigen Einstellung des Schwefelgehaltes im Absorber und des Selengehaltes im Puffer abhängt. In diesem zusätzlichen Freiheitsgrade liegt ein weiterer Vorteil dieser Erfindung. Zum Einstellen der optimalen elektronischen Struktur am Heteroübergang sind keine hohen Temperaturen zur Herbeiführung der richtigen Zusammensetzung durch Interdiffusion notwendig.

Erfindungsgemäß weist die Schwefel-Konzentration im Absorber einen abfallenden Gradienten von der Oberfläche, also der zur ersten Pufferschicht weisenden Grenzfläche, zum Inneren des Absorbers auf, wodurch der Wirkungsgrad ebenfalls positiv beeinflusst wird. Der Schwefelgradient kann beim Herstellungsprozess der CIS Absorber durch den Selenierungs- und Sulfurisierungsprozess von metallischen Schichten durch geeignete Temperatur- und Gaszeitprofile eingestellt werden. Das molare Verhältnis S/(Se+S) nimmt von der Oberfläche von 20% bis 60% auf Werte um 5-10% im Inneren der Absorberschicht ab, so dass das Verhältnis S/(Se+S) integral deutlich geringer ist, als an der Oberfläche. Zum Rückkontakt hin kann das Verhältnis S/(Se+S) auch wieder zunehmen. Der Gradient des Schwefels führt zu einem Gradienten in der Bandlücke. Dass ein fallender Gradient der Bandlücke in der Basis einer Solarzelle zu verbesserten Wirkungsgraden führen kann, ist aus verschiedenen Solarzellentechnologien bekannt. In der erfindungsgemäßen Kombination mit der amorphen Indiumsulfidschicht erlaubt der Gradient jedoch zusätzlich eine Anpassung der Bandstrukturen am Heteroübergang des Indiumsulfid/Cu(In,Ga)(S,Se)₂-Schichtsystems.

Vorteilhaft ist die In₂(S₁₋ₓ,Seₓ)_{3+δ}-Schicht zwischen 10 nm und 200 nm, insbesondere zwischen 40 nm und 140 nm, bevorzugt 60 nm dick, da hierdurch die Lichtabsorption durch die In₂(S₁₋ₓ, Seₓ)_{3+δ}-Pufferschicht gering ist.

Vorteilhaft umfasst das erfindungsgemäße Schichtsystem eine zweite Pufferschicht, die bevorzugt zwischen der ersten Pufferschicht und einer Frontelektrode angeordnet ist. Vorzugsweise umfasst die auf der ersten Pufferschicht aufgebrachte zweite Pufferschicht undotiertes Zn_{1-z}Mg_{z}O, wobei 0 ≤ z ≤ 1 ist. Ihre Schichtdicke beträgt zweckmäßig bis zu 200 nm, insbesondere 20 nm bis 140 nm, bevorzugt 60 nm.

Vorteilhaft ist eine Frontelektrode vorgesehen, die ein transparentes leitendes Oxid (TCO) umfasst. Insbesondere umfasst sie Indiumzinnoxid (ITO) und/oder ZnO, wobei dotiertes ZnO, insbesondere Al- oder Ga-dotiertes ZnO bevorzugt werden.

Als Träger in dem erfindungsgemäßen Schichtsystem ist vorzugsweise ein Metall, Glas-, Kunststoff oder Keramiksubstrat vorgesehen, wobei Glas bevorzugt wird. Es können aber auch andere transparente Trägermaterialien, insbesondere Kunststoffe verwendet werden.

Unter dem Absorber ist vorzugsweise eine Rückelektrode, z.B. Molybdän (Mo) oder andere Metalle umfassend, vorgesehen. In einer vorteilhaften Ausgestaltung der Rückelektrode weist diese eine Molybdänteilschicht auf, die an den Absorber angrenzt, und eine Siliziumnitridteilschicht (SiN), die an die Mo-Teilschicht angrenzt.

Unabhängiger Schutz wird für Solarzellen mit dem erfindungsgemäßen Schichtsystem und für Solarzellenmodule beansprucht, die diese Solarzellen beinhalten.

Zweckmäßig erfolgt das Verfahren zur Herstellung eines solchen Schichtsystems so, dass zumindest die Abscheidung der ersten Pufferschicht im Vakuum erfolgt, wobei bevorzugt die Erzeugung des gesamten Schichtsystems im Vakuum erfolgt.

Ein Vorteil dieses Vakuumprozesses besteht darin, dass dadurch zum einen eine höhere Materialausbeute erzielt wird. Außerdem ist er im Gegensatz zur Nassabscheidung umweltverträglicher, da im Gegensatz beispielsweise zur chemischen Badabscheidung einer Pufferschicht aus CdS keine kontaminierten Abwässer erzeugt werden. Schließlich können verschiedene Vakuumprozesse, wie auch die Herstellung der zweiten undotierten ZnO-Pufferschicht oder der dotierten ZnO-Frontelektrode in einer Anlage verbunden werden, wodurch die Herstellung preiswerter erfolgen kann. Je nach Ausgestaltung des Prozesses zur Herstellung des Absorbers ist auch eine Kombination mit dem Absorberprozess ohne Luftexposition denkbar.

Ein weiterer Vorteil besteht darin, dass durch das Vakuumverfahren der Einbau von Sauerstoff oder Hydroxid verhindert wird. Hydroxid-Komponenten in der Pufferschicht stehen nämlich im Verdacht, verantwortlich für Transienten des Wirkungsgrades bei Einwirkung von Wärme und Licht zu sein.

Vorteilhaft erfolgt die Aufbringung der Pufferschicht bei Temperaturen kleiner gleich 150 °C, insbesondere kleiner gleich 130 °C und bevorzugt zwischen 50°C und 100 °C. Dadurch können die Kosten der Vakuumanlage gesenkt werden. Im Gegensatz dazu müssen beispielsweise Indiumsulfidpuffer auf Cu(In,Ga)Se₂, das keinen Schwefel umfasst, entweder bei Temperaturen höher als 150 °C abgeschieden werden oder der gesamte Zellenaufbau muss nach Abscheidung der ZnO-Frontelektrode bei höheren Temperaturen getempert werden. In der vorliegenden Erfindung sind Temperaturen für die Herstellung der Schicht deutlich kleiner als 150 °C möglich und der Zellenaufbau muss nicht nachgetempert werden. Dies könnte darin begründet liegen, dass die schwefelhaltige Oberfläche von Cu(In,Ga)(S,Se)₂ im erfindungsgemäßen Absorber/Puffer-Schichtaufbau bereits die richtige Bandanpassung zum Puffer besitzt.

Zweckmäßig wird die Absorberschicht in einem Avancis RTP- ("rapid thermal processing") Prozess aufgebracht. Dabei werden zunächst einer Vorläuferschicht auf das Substrat mit Rückelektrode abgeschieden: die Elemente Cu, In und Ga werden durch Sputtern sowie amorphes Selen durch thermisches Verdampfen aufgebracht. Bei diesen Prozessen liegt die Substrattemperatur unter 100°C, so dass die Schichten im wesentlichen als Metalllegierung plus elementares Selen unreagiert erhalten blieben. Anschließend wird diese Vorläuferschicht in einem schnellen Temperverfahren (RTP rapid thermal processing) in schwefelhaltiger Atmosphäre zum Cu(In,Ga)(S,Se)₂ Chalcopyrithalbleiter reagiert.

Vorteilhaft wird die erste Pufferschicht thermisch im Hochvakuum verdampft, wobei die Prozessbedingungen bevorzugt so gewählt werden, dass diese Pufferschicht auf der Absorberschicht amorph abgeschieden wird. Wesentlich für das erfindungsgemäße Schichtsystem ist also das Aufwachsen der amorphen Schicht auf dem polykristallinen Absorber. Da dünne Schichten auf unterschiedlichen Substraten verschieden aufwachsen, ist ein Nachweis nur auf dem eigentlichen Schichtsystem Absorber/Puffer oder in der vollständigen Solarzelle, nicht jedoch auf Zeugengläser (Kontrollproben), über Röntgenbeugung im streifenden Einfall und mittels Ramanspektroskopie möglich. Denkbar ist auch, dass sowohl die erste als auch die zweite Pufferschicht, wenn eine solche zum Einsatz kommt, mittels Hochfrequenzsputtern (RF-Sputtern) aufgebracht werden. Die Frontelektrode wird wiederum vorzugsweise in einem DC-Magnetronsputterverfahren aufgebracht.

Weitere Einzelheiten und Vorteile der vorliegenden Erfindung ergeben sich aus der nachfolgenden Beschreibung im Zusammenhang mit den Zeichnungen. Dabei zeigen:
- Fig.l: eine schematische Querschnittansicht des erfindungsgemäßen Schichtsystems,
- Fig. 2: eine graphische Darstellung der Wirkungsgradverteilung von 32 Zellen mit Indiumsulfidselenid-Puffer,
- Fig. 3: Ergebnisse der Ramanspektroskopie (vertikale Achse) an einer Dünnschichtzelle mit einer amorphen Indiumsulfidselenid-Pufferschicht (horizontale Achse),
- Fig. 4: Ergebnisse der Ramanspektroskopie (vertikale Achse) an einer Dünnschichtzelle mit einer kristallinen Indiumsulfidselenid-Pufferschicht (horizontale Achse), wobei zusätzlich berechnete Linen an den Positionen der CuInSe₂-, CuInS₂-, ZnO- und In₂S₃-Phasen eingezeichnet sind,
- Fig. 5: die Korrelation zwischen Raman-Linienbreite des Peaks bei 326 cm⁻¹ (vertikale Achse) und Linienbreite des (111)-Reflexes von kubischem Indiumsulfidselenid (horizontale Achse) und
- Fig. 6: den Zusammenhang zwischen Raman-Linienbreite des Peaks bei 326 cm⁻¹ (horizontal Achse) und Wirkungsgrad (vertikale Achse).

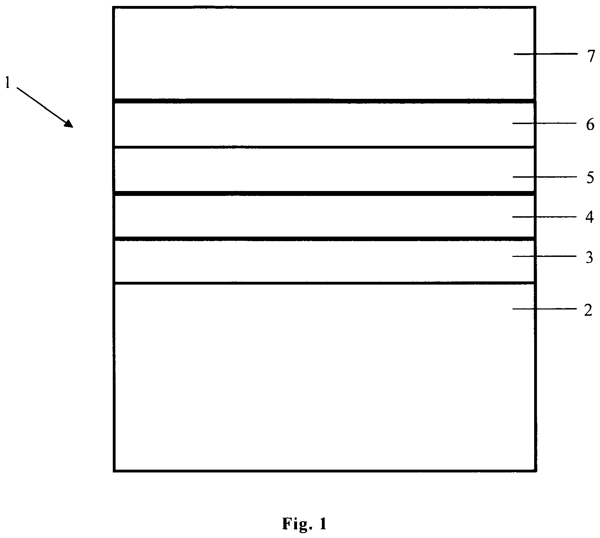

Anhand der Fig. 1 wird nachfolgend zunächst auf das erfindungsgemäße Schichtsystem und sein Herstellungsverfahren eingegangen.

Fig. 1 zeigt rein schematisch ein bevorzugtes Ausführungsbeispiel des erfindungsgemäßen Schichtsystems 1 in einer Querschnittsansicht. Das Schichtsystem 1 umfasst ein Substrat 2, eine Rückelektrode 3, eine Absorberschicht 4, eine erste Pufferschicht 5, eine zweite Pufferschicht 6 und eine Frontelektrode 7.

Das Herstellungsverfahren beginnt in üblicher Weise mit der thermischen Abscheidung der Rückkontaktschicht 3 aus Mo auf einem Glassubstrat 2. Statt der Rückelektrode 3 aus Mo kann auch eine geschichtete Elektrode aus einer ersten, auf dem Glassubstrat aufgebrachten SiN-Teilschicht und einer zweiten, darauf aufgebrachten Mo-Teilschicht verwendet werden, was die Eigenschaften dieses Rückkontakts verbessert. In einem weiteren Schritt wird die Absorberschicht 4 aus Cu(In,Ga)(S,Se)₂ auf der Rückelektrode 3 aufgebracht. In weiteren Schritten werden dann die erste Pufferschicht 5 aus In₂(S₁₋ₓ,Seₓ)_{3+δ}, die zweite Pufferschicht 6 aus undotiertem ZnO und anschließend eine Frontelektrode 7 aus ZnO dotiert mit Aluminium hergestellt.

Folgende Parameter werden dabei verwendet. Die Rückelektrode 3 aus Molybdän weist eine Schichtdicke von 400 nm auf. Die Absorberschicht 4 wird mit einer Dicke von 1,5 µm mit dem AVANCIS RTP-Prozess hergestellt. Die Oberfläche der Absorberschicht 4 weist eine Anionenzusammensetzung [S]/([Se]+[S]) von etwa 35% auf. Die Galliumkonzentration liegt an der Oberfläche unter 1%. Die In₂(S₁₋ₓ,Seₓ)_{3+δ}-Pufferschicht 5 wurde thermisch im Hochvakuum verdampft. Der Selengehalt der Pufferschicht x liegt bei 0 bis 3%. Die Stöchiometrieabweichung δ beträgt etwa -0,1 (das entspricht einer In₂S_{2.9}). Die Schichtdicke der ersten Pufferschicht beträgt 80 nm. Als zweite Pufferschicht wird 60 nm undotiertes ZnO durch einen RF-Sputterprozess abgeschieden. Als Frontelektrode wird 1200 nm ZnO:Al mit DC-Magnetronsputtern abgeschieden. Die Prozesstemperaturen bei Abscheidung der Absorberschicht 4 und der nachfolgenden Schichten 5, 6, 7 betragen deutlich unter 150 °C, nämlich 70°C.

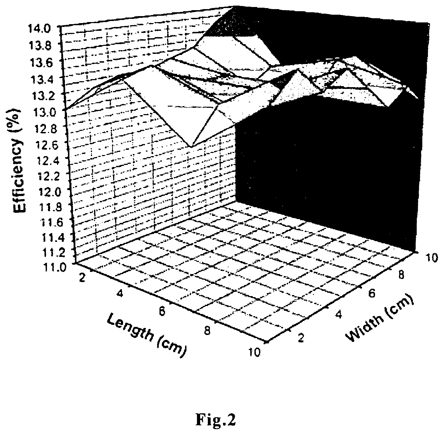

In Fig. 2 ist die Wirkungsgradverteilung von 32 Solarzellen, die gleichzeitig zusammen auf einem Glassubstrat der Größe 10 x 10 cm² (Aperturfläche 1,4 cm²) aufgebracht sind, dreidimensional dargestellt. Diese 32 Solarzellen beinhalten das obige erfindungsgemäße Schichtsystem und weisen einen Mittelwert des Wirkungsgrades von 13,2% auf. Der maximale Wert liegt bei 14,0%.

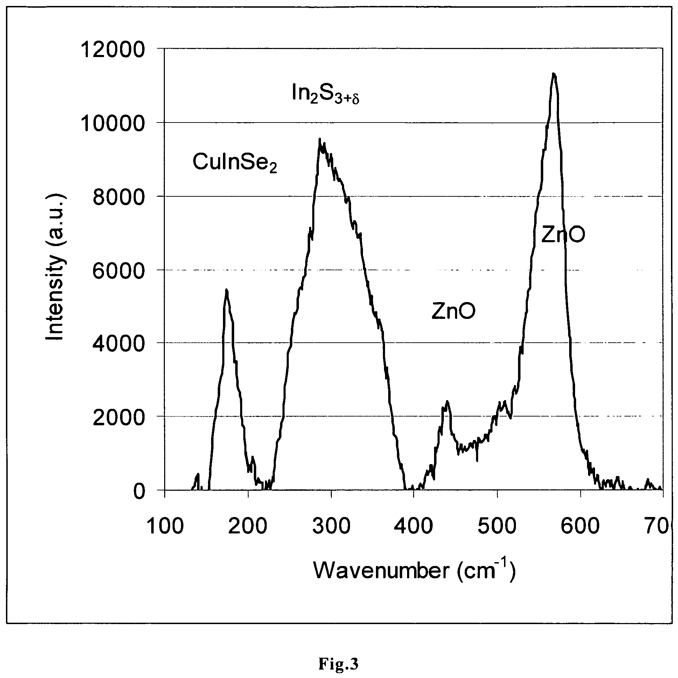

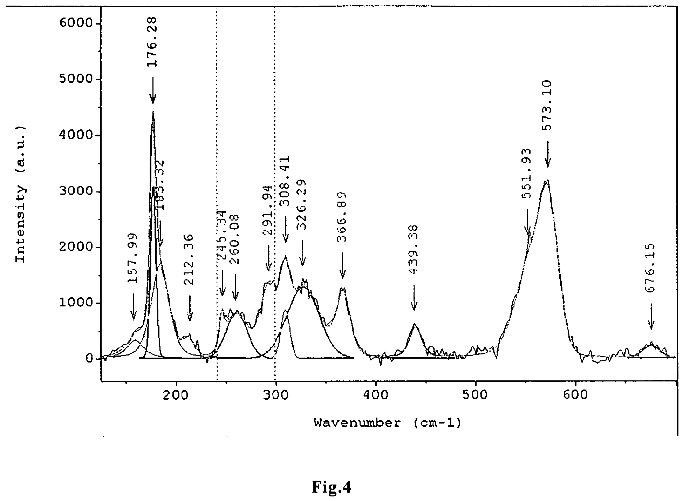

Die Ergebnisse von Ramanspektroskopie-Untersuchungen an fertigen Solarzellen-Bauelementen sind in Fig. 3 und Fig. 4 dargestellt. Diese Ramanspektren wurden bei Raumtemperatur mit einem Argonionen-Anregungslaser bei einer Wellenlänge von 488 nm für jeweils eine Solarzelle mit einer amorphen (Fig.3) und einer kristallinen In₂(S₁₋ₓ,Seₓ)_{3+δ}-Schicht (Fig.4) gemessen. Die kristalline In₂(S₁₋ₓ,Seₓ)_{3+δ}-Schicht zeichnet sich durch ein strukturiertes Spektrum aus, in dem die Einzellinien an den Positionen des Spektrums von β-In₂S₃ gut erkennbar sind. Die beobachteten Ramanmoden können den beitragenden Phasen CuInSe₂, CuInS₂, In₂S₃ und ZnO wie folgt zugeordnet werden: die Linie bei 179 cm⁻¹ und die benachbarten Nebenmodem bei 210 bis 220 cm⁻¹ der Phase CuInSe₂, die Linie bei 190 cm⁻¹ der Phase CuInS₂, die Linien bei 189, 244, 266, 306, 326 und 367 cm⁻¹ der Phase In₂S₃ und die Linien bei 430 und 570 cm⁻¹ inklusive der Flanke zu kleineren Wellenzahlen hin der Phase ZnO. Diese Schicht zeigt bei Röntgenbeugung (XRD) das Diffraktogramm von kubischem In₂S₃, was die kristalline Natur der Probe ebenfalls beweist. Bei der amorphen In₂(S₁₋ₓ,Seₓ)_{3+δ}-Schicht in Fig. 3 dagegen ist im Ramanspektrum ein unstrukturierter Berg in dem Wellenzahlenbereich zu sehen, in dem auch die Signale des kristallinen Indiumsulfids liegen, insbesondere im Bereich von 220 bis 380 cm⁻¹. Für diese Probe sind auch keine Reflexe in der Röntgenbeugung zu erkennen, die einer Indiumsulfid-Phase zugeordnet werden könnten.

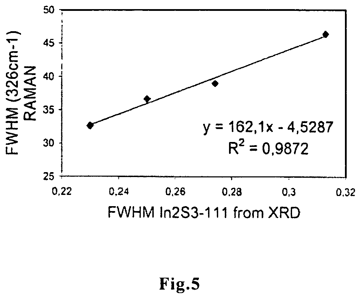

In Fig. 5 ist der Zusammenhang zwischen Ramanlinienbreite des Peaks bei 326 cm⁻¹ und Linienbreite des XRD (111) Reflexes von In₂(S₁₋ₓ,Seₓ)_{3+δ}-Schichten dargestellt. In den Fällen, wo Indiumsulfidreflexe im Diffraktogramm zu erkennen sind, korreliert die Breite der Ramanlinien gut mit der Breite des (111)-Reflexes aus dem Röntgenbeugungsdiffraktogramm. Je breiter die Linie des (111)-Reflexes ist, desto breiter ist die Ramanlinie und desto amorpher ist die Struktur der Probe. In Fig. 5 ist auch der ermittelte Zusammenhang zwischen beiden Linienbreiten formelmäßig angegeben. Die Breite der Ramanlinie wurde durch Anpassung von Gauß-Lorentzlinien an den eingezeichneten Linienpositionen von In₂S₃ bestimmt.

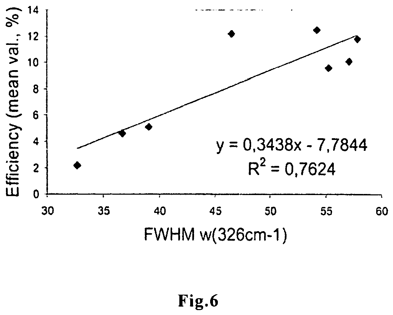

Fig. 6 zeigt wiederum den Zusammenhang zwischen Ramanlinienbreite des Peaks bei 326 cm⁻¹ und Wirkungsgrad für die In₂(S₁₋ₓ,Seₓ)_{3+δ}-Schichten. Zu erkennen ist, dass je breiter die Ramanlinie, d.h. je amorpher die Struktur ist, der Wirkungsgrad der Schichten desto höher ist. Das bedeutet, dass sehr gute Solarzellen, d.h. Zellen mit einem hohen Wirkungsgrad, bei den hier untersuchten Prozessparametern und den verwendeten Absorbern sich durch ein unstrukturiertes Ramanspektrum, stark verbreiterte Ramanlinie und das Fehlen von kristallinen Röntgenbeugungsreflexen der Indiumsulfidschicht auszeichnen. In Fig. 6 ist auch der ermittelte Zusammenhang zwischen der Ramanlinienbreite des Peaks bei 326 cm⁻¹ und Wirkungsgrad formelmäßig angegeben. Bei stark amorphen Schichten wird die Bestimmung der Linienbreite ungenau. Die Schichten mit gänzlich unstrukturiertem Spektrum führen zu den besten Solarzellenwirkungsgraden.

Aus den vorstehenden Ausführungen ist klar geworden, dass durch die vorliegende Erfindung die Nachteile von bisher verwendeten CdS-Pufferschichten bzw. den alternativen Pfufferschichten bei Dünnschichtsolarzellen überwunden werden konnten, wobei der Wirkungsgrad und die Stabilität der damit erzeugten Solarzellen ebenfalls sehr gut ist. Gleichzeitig ist das Herstellungsverfahren kostengünstig, effektiv und umweltschonend.

## Patentansprüche

1. Schichtsystem (1) für Dünnschichtsolarzellen, das eine Absorberschicht (4) und eine erste Pufferschicht (5) umfasst, wobei die Absorberschicht (4) auf der Basis eines Cu(In,Ga)(S_{1-y},Se_{y})₂-Verbindungshalbleitermaterials gebildet ist, wobei 0 ≤ y ≤ 1 gilt, wobei die erste Pufferschicht (5) amorph ist und die erste Pufferschicht (5) In₂(S₁₋ₓ,Seₓ)_{3+δ} umfasst, wobei 0 ≤ x ≤ 1 gilt, **dadurch gekennzeichnet, dass** die Abweichung δ von der Stöchiometrie zwischen -0,2 und 0 liegt, und das Verhältnis der molaren Konzentrationen [S]/([Se]+[S]) an der der ersten Pufferschicht (5) zugewandten Oberfläche der Absorberschicht (4) von 20% bis 60% beträgt und auf Werte von 5% bis 10% im Innern der Absorberschicht abnimmt.

2. Schichtsystem (1) gemäß Anspruch 1, **dadurch gekennzeichnet, dass** der Selengehalt 0 ≤ x ≤ 0,5, bevorzugt 0 ≤ x ≤ 0,1 beträgt.

3. Schichtsystem (1) gemäß Anspruch 1 oder 2, **dadurch gekennzeichnet, dass** das Verhältnis der molaren Konzentrationen [S]/([Se]+[S]) an der der ersten Pufferschicht (5) zugewandten Oberfläche der Absorberschicht (4) 35% beträgt.

4. Schichtsystem (1) gemäß einem der vorherigen Ansprüche, **dadurch gekennzeichnet, dass** die Schichtdicke der ersten Pufferschicht (5) zwischen 10 nm und 200 nm liegt, insbesondere zwischen 40 nm und 140 nm, bevorzugt 80 nm.

5. Schichtsystem (1) gemäß einem der vorherigen Ansprüche, **dadurch gekennzeichnet, dass** zusätzlich eine zweite Pufferschicht (6) vorgesehen ist, die bevorzugt auf der ersten Pufferschicht (5) angeordnet ist.

6. Schichtsystem (1) gemäß Anspruch 5, **dadurch gekennzeichnet, dass** die zweite Pufferschicht (6) undotiertes Zn_{1-z}Mg_{z}O umfasst, wobei 0 ≤ z ≤ 1 beträgt.

7. Schichtsystem (1) gemäß Anspruch 5 oder 6, **dadurch gekennzeichnet, dass** die Schichtdicke der zweiten Pufferschicht bis zu 200 nm beträgt, insbesondere 10 nm bis 140 nm, bevorzugt 60 nm.

8. Schichtsystem (1) gemäß einem der vorherigen Ansprüche, **dadurch gekennzeichnet, dass** oberhalb der ersten Pufferschicht (5) eine Frontelektrode (7) angeordnet ist, die aus einem transparenten leitenden Oxid (TCO), bevorzugt Al- oder Ga-dotiertes ZnO, besteht.

9. Solarzelle oder Solarzellenmodul, **gekennzeichnet durch** das Schichtsystem (1) nach einem der vorherigen Ansprüche.

## Claims

1. Layer system (1) for solar cells, that comprises an absorber layer (4) and a first buffer layer (5), in which the absorber layer (4) is formed based on a
Cu(In,Ga)(S_{1-y},Se_{y})₂ - compound semiconductor material, wherein 0 ≤ y ≤ 1, wherein the first buffer layer (5) is amorphous and the first buffer layer (5) comprises In₂(S₁₋ₓ,Seₓ)_{3+δ}, wherein 0 ≤ x ≤ 1, **characterized in that** the deviation δ from stoichiometry is between -0.2 and 0, and the ratio of the molar concentrations [S]/([Se]+[S]) on the surface of the absorber layer (4) facing the first buffer layer (5) is between 20% and 60% and is decreasing to values of 5% to 10% in the interior of the absorber layer (4).

2. Layer system (1) according to claim 1, **characterized in that** the selenium content is 0 ≤ x ≤ 0.5, preferably 0 ≤ x ≤ 0.1.

3. Layer system (1) according to claim 1 or 2, **characterized in that** the ratio of the molar concentrations [S]/([Se]+[S]) on the surface of the absorber layer (4) facing the first buffer layer (5) is 35%.

4. Layer system (1) according to one of the preceding claims, **characterized in that** the layer thickness of the first buffer layer (5) is between 10 nm and 200 nm, in particular, between 40 nm and 140 nm, preferably 80 nm.

5. Layer system (1) according to one of the preceding claims, **characterized in that**, in addition, a second buffer layer (6) is provided that is preferably disposed on the first buffer layer (5).

6. Layer system (1) according to claim 5, **characterized in that** the second buffer layer (6) comprises undoped Zn_{1-z}Mg_{z}O, wherein 0 ≤ z ≤ 1.

7. Layer system (1) according to claim 5 or 6, **characterized in that** the layer thickness of the second buffer layer is up to 200 nm, in particular 10 nm to 140 nm, preferably 60 nm.

8. Layer system (1) according to one of the preceding claims, **characterized in that** above the first buffer layer (5), a front electrode (7) that consists of a transparent conductive oxide (TCO), preferably Al- or Ga-doped ZnO, is disposed.

9. Solar cell or solar cell module, **characterized by** the layer system (1) according to one of the preceding claims.

## Revendications

1. Système stratifié (1) pour cellules solaires à couches minces, qui comprend une couche d'absorption (4) et une première couche tampon (5), où la couche d'absorption (4) est formée sur la base d'un matériau semi-conducteur composé Cu(In,Ga)(S_{1-y},Se_{y})₂, où 0 ≤ y ≤ 1 est valable, où la première couche tampon (5) est amorphe et la première couche tampon (5) comprend In₂(S_{1-X},Se_{X})_{3+δ}, où 0 ≤ x ≤ 1 est valable, **caractérisé en ce que** l'écart de la stoechiométrie est entre -0,2 et 0, et le rapport des concentrations molaires [S]/[[Se] [S]) sur la surface de la couche d'absorption (4) tournée vers la première couche tampon (5) est de 20% à 60% et diminue à des valeurs de 5% à 10% à l'intérieur de la couche d'absorption.

2. Système stratifié (1)) selon la revendication 1, **caractérisé en ce que** le contenu en sélénium est 0 ≤ x ≤ 0,5, de préférence 0 ≤ x ≤ 0,1.

3. Système stratifié (1) selon la revendication 1 ou 2, **caractérisé en ce que** le rapport des concentrations molaires [S]/([Se]+[S]) à la surface de la couche d'absorption (4) tournée vers la première couche tampon (5) est de 35 %.

4. Système stratifié (1) selon l'une des revendications précédentes, **caractérisé en ce que** l'épaisseur de la couche de la première couche tampon (5) se situe entre 10 nm et 200 nm, en particulier entre 40 nm et 140 nm, de préférence 80 nm.

5. Système stratifié (1) selon l'une des revendications précédentes, **caractérisé en ce qu'**en outre une deuxième couche tampon (6) est fournie, qui est disposée de préférence sur la première couche tampon (5).

6. Système stratifié selon la revendication 5, **caractérisé en ce que** la deuxième couche tampon (6) comprend du Zn_{1-z}Mg_{z}O non dopé, où 0 ≤ z ≤ 1.

7. Système stratifié (1) conformément à la revendication 5 ou 6, **caractérisé en ce que** l'épaisseur de couche de la deuxième couche tampon se situe à jusqu'à 200 nm, en particulier entre 10 nm et 140 nm, de préférence 60 nm.

8. Système stratifié (1) selon l'une des revendications précédentes, **caractérisé en ce qu'**une électrode avant (7), qui est composée d'un oxyde conducteur transparent (TCO), de préférence ou du ZnO dopé au Al ou au Ga est disposée au-dessus de la première couche tampon (5).

9. Cellule solaire ou module de cellules solaires, **caractérisé par** le système stratifié (1) selon l'une des revendications précédentes.
